Europäisches Patentamt

European Patent Office

Office européen des brevets

(19)

(11) **EP 0 758 689 B1**

(12) **EUROPÄISCHE PATENTSCHRIFT**

(45) Veröffentlichungstag und Bekanntmachung des Hinweises auf die Patenterteilung:
**10.11.1999 Patentblatt 1999/45**

(51) Int Cl.⁶: **C30B 15/00**, C30B 30/04

(21) Anmeldenummer: **96112765.1**

(22) Anmeldetag: **08.08.1996**

(54) **Verfahren und Vorrichtung zur Herstellung von Einkristallen**

Process and apparatus for growing single crystals

Procédé et appareil pour la croissance d'un monocristal

(84) Benannte Vertragsstaaten:
**DE GB IT**

(30) Priorität: **10.08.1995 DE 19529481**

(43) Veröffentlichungstag der Anmeldung:
**19.02.1997 Patentblatt 1997/08**

(73) Patentinhaber: **Wacker Siltronic Gesellschaft für Halbleitermaterialien Aktiengesellschaft
84489 Burghausen (DE)**

(72) Erfinder:
- **Tomzig, Erich, Dr.
  84508 Burgkirchen (DE)**
- **Zulehner, Werner, Dr.
  84489 Burghausen (DE)**
- **von Ammon, Wilfried, Dr.
  84489 Burghausen (DE)**
- **Gelfgat, Yu M., Prof. Dr.
  Riga 1010 (LV)**
- **Gorbunov, L.A., Dr.
  Riga LV-1063 (LV)**

(74) Vertreter: **Rimböck, Karl-Heinz, Dr. et al
c/o Wacker-Chemie GmbH
Zentralabteilung PML
Hans-Seidel-Platz 4
81737 München (DE)**

(56) Entgegenhaltungen:
US-A- 5 178 720

- MAGNITNAYA GIDRODINAMIKA, JULY-SEPT. 1979, USSR, Bd. 15, Nr. 3, ISSN 0025-0015, Seiten 145-146, XP000603324 IVANOV A A ET AL: "Electromagnetic excitation of oscillations in a crystallizing bar"
- FIFTH HUNGARIAN CONFERENCE ON CRYSTAL GROWTH HCCG-5, BUDAPEST, HUNGARY, 14-16 NOV. 1989, Bd. 70, Nr. 3, ISSN 0231-4428, ACTA PHYSICA HUNGARICA, 1991, HUNGARY, Seiten 177-181, XP002017107 BOCHKAREV E P ET AL: "Properties of silicon single crystals grown in magnetic fields"
- JOURNAL OF CRYSTAL GROWTH, Bd. 52, 1981, AMSTERDAM, Seiten 524-529, XP000604638 MIKELSON ET AL: "CONTROL OF CRYSTALLIZATION PROCESS BY MEANS OF MAGNETIC FIELDS"

EP 0 758 689 B1

## Beschreibung

Gegenstand der Erfindung ist ein Verfahren zur Herstellung von Einkristallen aus Halbleitermaterial nach der Czochralski-Methode. Bei dieser Methode wächst ein zylindrischer Einkristall auf einem Impfkristall auf, wobei der Impfkristall zunächst in eine Schmelze getaucht und anschließend von der Oberfläche der Schmelze weggezogen wird. Die Schmelze befindet sich in einem Tiegel, der aus einem Quarzglastiegel und aus einem, üblicherweise aus Graphit gefertigten, Stütztiegel besteht, in den der Quarzglastiegel eingelegt ist. Der Tiegel ruht auf einer drehbaren und axial verschiebbaren Welle und ist seitlich von Widerstands-Heizelementen umgeben, die ausreichend Wärmestrahlung erzeugen, um darin festes Halbleitermaterial zu schmelzen und in geschmolzenem Zustand zu halten. Die Schmelze enthält neben Halbleitermaterial gegebenenfalls zugesetzte Dotierstoffe und unvermeidbare Anteile von Sauerstoff und anderen Verunreinigungen, die aus der Tiegelwand herausgelöst werden. In der Regel werden der Tiegel und der wachsende Einkristall gegensinnig gedreht, weil dadurch der quantitative Einbau von Sauerstoff und die Verteilung von Sauerstoff und Dotierstoffen in der Schmelze und im Einkristall zu einem gewissen Grad beeinflußt werden kann.

Die Schmelze verliert hauptsächlich über ihre freie Oberfläche, den wachsenden Einkristall, den Boden des Stütztiegels und die Welle ständig an Wärme. Dieser Wärmeverlust muß durch eine Erhöhung der Heizleistung der Widerstands-Heizelemente ausgeglichen werden. Die erhöhte Wärmezufuhr heizt die Tiegelwand weit über den Schmelzpunkt des Halbleitermaterials hinaus auf. Dies ist ein Problem mit nachteiligen Folgen, die sich insbesondere bei der Herstellung von Einkristallen mit Durchmessern von mehr als 200 mm bemerkbar machen, weil zur Herstellung solcher Einkristalle wegen entsprechend groß dimensionierter Tiegel und Schmelzenvolumina hohe Heizleistungen notwendig sind. Eine Folge ist, daß durch die hohen Temperaturen an der Tiegelwand verstärkt Sauerstoff und andere Verunreinigungen aus dem Tiegelmaterial gelöst werden und in die Schmelze gelangen. Eine andere ungünstige Folge ist, daß sich durch die Überhitzung des Tiegels auf der Tiegelwand vermehrt inselartige Cristobalit-Strukturen ausbilden. Von diesen können sich durch Lochkorrosion Partikel lösen, die mit einer gewissen Wahrscheinlichkeit über Konvektionsströmungen bis zur Kristallisationsgrenze gelangen und das versetzungsfreie Wachstum des Einkristalls beenden können. Aus diesem Grund ist das bisher erreichbare versetzungsfreie Längenwachstum von Einkristallen mit großen Durchmessern recht limitiert und das Verhältnis von Länge zu Durchmesser bei solchen Einkristallen gering. Eine weitere nachteilige Folge einer zu hohen Temperatur an der Tiegelwand resultiert aus der damit verbundenen großen Temperaturdifferenz zwischen dem Tiegel und der Kristallisationsgrenze. Sie ist Ursache für das Auftreten von starken unkontrollierten Stoffströmen in der Schmelze in Folge von thermischer Konvektion, die zu lokalen Schwankungen der Temperatur und der Konzentration von Dotierstoff und Verunreinigungen führen. Natürlich spiegelt sich diese Situation auch im gewachsenen Einkristall durch eine unerwünschte, lokal schwankende Verteilung der Dotierstoffe und der Verunreinigungen, insbesondere des Sauerstoffs, wieder.

Darüber hinaus verstärken die Temperaturschwankungen in der Schmelze die temperaturbedingten Spannungen, denen der Einkristall beim Wachsen ausgesetzt ist. Die Gefahr steigt, daß im Bereich der Kristallisationsgrenze Versetzungen entstehen, die sich bis zu einer dem Durchmesser des Einkristalls entsprechenden Länge in den versetzungsfreien Teil des Einkristalls ausbreiten können. Weil versetzte Kristallbereiche zur Verwendung als Grundstoff für elektronische Bauelemente nicht geeignet sind, ist insbesondere bei großen Einkristallen, bei denen das Verhältnis von Länge zu Durchmesser aus den genannten Gründen ohnehin gering ist, mit herben Ausbeuteverlusten zu rechnen.

Es ist beispielsweise aus der DD-270 728 A1 bekannt, daß statische Magnetfelder, die der Schmelze aufgeprägt werden, Stoffströme und Temperaturverteilung in der Schmelze beeinflussen. Ihre Wirkung besteht vor allem in einer Dämpfung konvektiver Stoffströme. Bei geeigneten Feldstärken werden lokale Temperaturschwankungen vermindert und der Dotierstoffeinbau in den Einkristall homogener. Allerdings sind die zur Erzeugung von Magnetfeldern mit geeigneten Feldstärken benötigten Magnete konstruktiv aufwendig und ihr Energiebedarf ist verhältnismäßig hoch. In der oben genannten Schrift und in der US-5178720 werden daher Verfahren favorisiert, die mit rotierenden Magnetfeldern arbeiten. Die Kontrolle des Einbaus von Sauerstoff in den wachsenden Einkristall geschieht gemäß dem in der US-5178720 offenbarten Verfahren nach einem Ablaufprotokoll, demzufolge bestimmte Drehgeschwindigkeiten von Einkristall und Tiegel zu beachten sind und die Intensität einer bestimmten Komponente des Magnetfelds mit zunehmenden Kristallvolumen verringert wird.

Trotz einiger Verbesserungen durch den Einsatz statischer und rotierender Magnetfelder bei der Herstellung von Einkristallen nach der Czochralski-Methode bleibt die Situation unbefriedigend. Die bekannten Verfahren bieten insbesondere noch keine ausreichende Lösung der geschilderten Probleme, die bei der Herstellung von Einkristallen mit Durchmessern von mehr als 200 mm zu bewältigen sind.

Es war daher die Aufgabe der Erfindung, Abhilfe zu schaffen und ein Verfahren anzugeben, das sich insbesondere zur Herstellung großer Einkristalle eignet, das eine homogene Verteilung der Dotierstoffe und der Verunreinigungen im Einkristall ermöglicht, mit dessen Hilfe die Aufnahme von Sauerstoff in den Einkristall auch mengenmäßig kontrolliert werden kann und durch das die Gefahr der Versetzungsbildung stark eingeschränkt ist.

Gelöst wird Aufgabe durch ein Verfahren zur Herstellung eines Einkristalls aus Halbleitermaterial nach der

2

Czochralski-Methode durch Wegziehen eines in eine Schmelze getauchten Impfkristalls von der Oberfläche der Schmelze, wobei sich die Schmelze bis zu einer bestimmten Höhe in einem drehbaren Quarzglastiegel befindet und durch Aufschmelzen von festem Halbleitermaterial und gegebenenfalls Dotierstoffen erzeugt wird, und die Schmelze während des Kristallwachstums unter dem Einfluß eines Magnetfelds steht, das dadurch gekennzeichnet ist, daß das Magnetfeld durch Überlagern eines statischen Magnetfelds und eines alternierenden Magnetfelds erzeugt wird.

Durch den kombinierten Einsatz eines statischen und eines alternierenden Magnetfelds wird es möglich, konvektive Stoffströme und die Temperaturverteilung in der Schmelze an die Erfordernisse für ein optimales Kristallwachstum anzupassen. Über das alternierende Magnetfeld läßt sich induktiv Energie in die Schmelze einkoppeln, ohne daß dabei die Tiegelwand miterhitzt werden muß. Dabei lassen sich Stoffströme gezielt erzeugen, die eine homogene Dotierstoff- und Sauerstoffverteilung in der Schmelze, vor allem im Bereich der Kristallisationsgrenze begünstigen. Das alternierende Magnetfeld wird dabei auch als Instrument verwendet, um die Stoffströme zu kontrollieren, indem Änderungen der Wachstums-Bedingungen, die sich zwangsläufig ergeben, durch eine Veränderung des Magnetfelds kompensiert werden oder veränderte Wachstums-Bedingungen durch eine Veränderung der Magnetfelds bewußt herbeigeführt werden. Das überlagerte, statische Magnetfeld ist wiederum notwendig, um die Stoffströme zu stabilisieren, zu regeln und um lokale Schwankungen der Strömungsgeschwindigkeiten zu dämpfen.

Die weitere Beschreibung der Erfindung erfolgt an Hand von Figuren.

Figur 1 zeigt die bevorzugten Bedingungen bezüglich der radialen Temperaturverteilung und der Verteilung konvektiver Stoffströme in der Schmelze.

In Figur 2 ist der Aufbau einer Vorrichtung gemäß einer ersten Ausführungsform skizziert, die zur Durchführung des Verfahrens geeignet ist.

Figur 3 zeigt ein schematisches, elektrisches Diagramm für eine Vorrichtung gemäß einer zweiten Ausführungsform der Erfindung.

Figur 4 zeigt ein schematisches, elektrisches Diagramm für eine Vorrichtung gemäß einer dritten Ausführungsform der Erfindung.

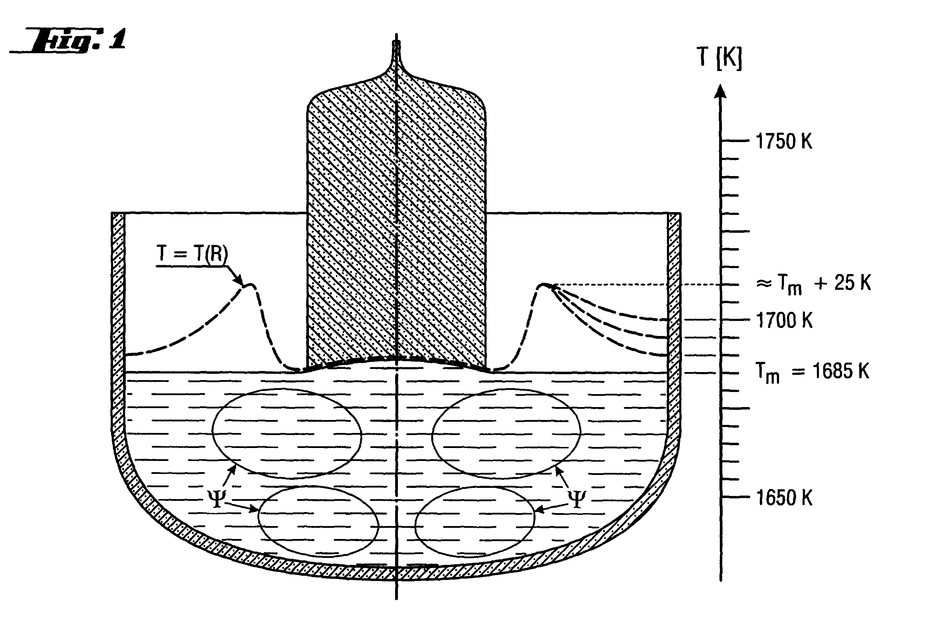

Um die in Figur 1 gezeigte, bevorzugte Temperaturverteilung und das von geschlossenen Kreisläufen gekennzeichnete Stoffstrom-Profil zu verwirklichen, wird vorgeschlagen, der Schmelze ein alternierendes Magnetfeld und gleichzeitig ein statisches Magnetfeld aufzuprägen. Besonders bevorzugt ist es, ein axialsymmetrisches, alternierendes Magnetfeld mit der relativen Frequenz $\varepsilon = 2\pi\mu_o\sigma fR^2$ einzusetzen, das eine magnetische Induktion mit einer Amplitude von mindestens $B_a = C/R$ aufweist, wobei $\varepsilon$ vorzugsweise im niederfrequenten Bereich von 1 bis 1000, besonders bevorzugt von 5 bis 50, liegen sollte. In den Ausdrücken bedeuten $\mu_o$ die magnetische Permeabilität im Vakuum ( $\mu_o = 4\pi 10^{-7}$ H/m), $\sigma$ die elektrische Leitfähigkeit der Schmelze, f die Wechselstromfrequenz der Stromversorgung für die Induktionsspule, die das alternierende Magnetfeld erzeugt, R der Radius des Tiegels und C eine Konstante, deren Wert $1*10^{-3}$ T*m beträgt. Durch Wechselwirkung mit dem alternierenden Magnetfeld werden in der Schmelze elektrische Ströme induziert, die auf azimutalen Bahnen um die Drehachse des Tiegels zirkulieren. Deren Wechselwirkung mit dem Magnetfeld ist letztlich für das Auftreten der in Figur 1 skizzierten, konvektiven Stoffströme $\Psi$ verantwortlich. Über die relative Frequenz $\varepsilon$ wird die Intensität und die Lage dieser Stoffströme und damit das Ausgasen von Siliciummonoxid über die freie Oberfläche der Schmelze beeinflußt und letztlich der Einbau von Sauerstoff in den Einkristall in weiten Grenzen gesteuert.

Wegen des ohmschen Widerstands, den die Schmelze dem induzierten elektrischen Strom entgegensetzt, wird die Schmelze vor allem im Bereich zwischen dem Einkristall und der Tiegelwand zusätzlich erhitzt. Die Folge davon ist eine radiale Temperaturverteilung T(R) mit einem Maximum in diesem Bereich. Die in der Figur 1 am Beispiel einer Silicium-Schmelze dargestellte, bevorzugte Temperaturverteilung unterscheidet sich wesentlich von der bisher bei der Czochralski-Methode üblichen Temperaturverteilung mit dem Temperaturmaximum an der Tiegelwand. Gemäß Figur 1 liegt die Temperatur an der Tiegelwand und im Bereich der Kristallisationsgrenze nur geringfügig über dem Schmelzpunkt des Halbleitermaterials. Die Temperatur an der Tiegelwand beeinflußt den Eintrag von Sauerstoff in die Schmelze. Es ist daher im Einzelfall zu entscheiden, welche Temperatur eingestellt wird. Bewährt haben sich Temperaturen, die bis 25°C, bevorzugt bis 5°C über dem Schmelzpunkt $T_m$ des Halbleitermaterials liegen. Das Temperaturmaximum im Bereich zwischen dem Einkristall und der Tiegelwand liegt vorzugsweise 15 bis 35°C über dem Schmelzpunkt des Halbleitermaterials. Der Abstand des Temperaturmaximums zur Tiegelwand beträgt bevorzugt 50 bis 75 % des Abstands zwischen Tiegelwand und Oberfläche des Einkristalls. Um die angestrebte Temperatur an der Tiegelwand einzustellen, wird die Heizleistung der den Tiegel umgebenden Widerstandsheizung vor Beginn des Wachstums des Einkristalls nötigenfalls gedrosselt. Durch die relativ niedrige Temperatur an der Tiegelwand ist die Rate, mit der Sauerstoff und andere Verunreinigungen aus dem Tiegelmaterial herausgelöst werden, erheblich reduziert. Ebenso verringert sich die Kontamination der Schmelze durch Partikel, weil auch die Bildung und Ablösung von Cristobalit-Inseln an der Tiegelwand bei niedrigeren Temperaturen zurückgeht.

Eine Ausgestaltung der Erfindung sieht vor, die Heizleistung der Widerstandsheizung soweit zu verringern, daß eine dünne Schicht aus Halbleitermaterial an der Tiegelwand auskristallisiert, wodurch der vom Tiegel stammende Eintrag von Partikeln, Sauerstoff und anderen Verunreinigungen in die Schmelze vollständig unterbunden wird. Einkristalle, die nach dieser Verfahrensvariante hergestellt werden, weisen in bezug auf Reinheit und Sauerstoffgehalt Produkteigenschaften auf, die mit denen von zonengezogenen Einkristallen ("float zone grown crystals") vergleichbar sind. Die ergänzende Anwendung des zweiten, aber statischen Magnetfelds während des Wachstums des Einkristalls stabilisiert und steuert die hauptsächlich vom alternierenden Magnetfeld erzeugten konvektiven Stoffströme in der Schmelze und dämpft lokale Schwankungen von Temperatur und Stoffstrom-Geschwindigkeiten. Der Einfluß des statischen Magnetfelds unterstützt die Vergleichmäßigung der Konzentrationen von Dotierstoffen, Sauerstoff und anderen Verunreinigungen vor allem im Bereich der Kristallisationsgrenze und fördert dabei auch den gleichmäßigen Einbau dieser Stoffe in den wachsenden Einkristall. Darüber hinaus sorgt er für eine Beruhigung der Schmelze im Bereich der Tiegelwand und trägt dadurch ebenfalls dazu bei, daß der Übertritt von Sauerstoff und anderen Verunreinigungen in die Schmelze verringert wird. Es ist bevorzugt, ein statisches Magnetfeld einzurichten, das eine magnetische Induktion $B_c = \sqrt{B_r^2 + B_z^2}$ aufweist, deren Betrag gleich oder größer ist als 0,05 T, wobei $B_r$ und $B_z$ die radialen und axialen Komponenten der magnetischen Induktion bezüglich der Drehachse des Tiegels sind. Die Feldlinien des statischen Magnetfelds können den Tiegel und die Schmelze axial ($B_r=0$; $B_z>0$), transversal ($B_r>0$; $B_z=0$) oder axial-radial ($B_r>0$; $B_z>0$) durchdringen. Die optimale Ausrichtung der Feldlinien ist durch Vorversuche zu ermitteln, da sie je nach angestrebter Kristall-Spezifikation unterschiedlich sein kann.

Gemäß einer Ausführungsform des Verfahrens wird das alternierende Magnetfeld auch dazu verwendet, um festes Halbleitermaterial im Tiegel zu schmelzen. Bevorzugt wird die notwendige Schmelzenergie zu einem Teil von der Widerstandsheizung und zu einem anderen Teil auf induktivem Weg durch das alternierende Magnetfeld bereitgestellt. Dies hat den Vorteil, daß der Quarzglastiegel geschont wird und sich die Lebensdauer des wiederverwendbaren, teueren Stütztiegels verlängert, weil die von der Widerstandsheizung abgegebene Wärmestrahlung, die auch den Stütztiegel belastet, bereits während des Schmelzvorgangs gedrosselt werden kann. Inbesondere wird aber die Aufschmelzzeit deutlich verkürzt und der Eintrag von Verunreinigungen in die Schmelze verringert. Darüber hinaus setzt bereits beim Schmelzen des Halbleitermaterials die von der Wirkung des alternierenden Magnetfelds verursachte Homogenisierung der Schmelze ein. Diese Vorteile können am Anfang des Verfahrens genutzt werden, um festes Halbleitermaterial, mit dem der Tiegel gefüllt worden ist, zu schmelzen, und gegebenenfalls auch später, um Halbleitermaterial zu schmelzen, das in die bestehende Schmelze, beispielsweise in Form von Granulat, kontinuierlich oder absatzweise nachchargiert wird.

Eine bevorzugte Ausführungsform des Verfahrens umfaßt im wesentlichen die nachfolgend beschriebenen Verfahrensschritte. Das im Tiegel gegebenenfalls zusammen mit Dotierstoff vorgelegte, feste Halbleitermaterial wird zunächst mit Hilfe der Widerstandsheizung soweit erhitzt, bis auch genügend Energietransfer über das alternierende Magnetfeld möglich ist. Die weitere Wärmezufuhr erfolgt dann dann gemeinsam durch die Widerstandsheizung und das alternierende Magnetfeld, wobei die Heizleistung der Widerstandsheizung gegebenenfalls dem Energiebeitrag des Magnetfelds entsprechend herabgesetzt wird. Nachdem alles Material geschmolzen ist und der Tiegel mit der Schmelze bis zu einer bestimmten Schmelzenhöhe gefüllt ist, wird, gegebenenfalls nach einer bestimmten Wartezeit und einer Drosselung der Heizleistung der Widerstandsheizung, der Schmelze zusätzlich das statische Magnetfeld aufgeprägt und mit dem Ziehen des Einkristalls begonnen. Der Impfkristall wird in die Schmelze eingetaucht und in üblicher Weise mit einer bestimmten Geschwindigkeit von der Oberfläche der Schmelze nach oben weggezogen, wobei an seiner Unterseite der Einkristall aufwächst. Tiegel und Einkristall drehen sich dabei vorzugsweise gegensinnig mit bestimmten Drehzahlen. Das Kristallwachstum durchläuft dabei die bekannten Phasen, während derer Dünnhals, Anfangskonus, zylindrischer Teil und Endkonus des Einkristalls gezogen werden. Bevorzugt ist es, auf die ständige Abnahme des verfügbaren Schmelzenvolumens in Folge des Wachstums des Einkristalls mit einer Änderung der Amplitude der magnetischen Induktion $B_a$ des alternierenden Magnetfelds zu reagieren. Besonders bevorzugt erfolgt die Änderung in Abhängigkeit der fallenden Schmelzenhöhe gemäß der Gleichung $B_a = B_{ao} \cdot \sqrt{h_o/h}$, wobei $B_a$ die geänderte Amplitude, $B_{ao}$ die anfängliche Amplitude, h die tatsächliche Schmelzenhöhe und $h_o$ die anfängliche Schmelzenhöhe sind.

Gegenstand der Erfindung ist auch eine Vorrichtung zur Herstellung eines Einkristalls aus Halbleitermaterial nach der Czochralski-Methode, mit einem Rezipienten, in dem ein mit einer Schmelze gefüllter Tiegel und eine den Tiegel umgebende Widerstands-Heizung untergebracht sind, mit einer Zieheinrichtung zum Ziehen eines Einkristalls aus der Schmelze und mit einer Einrichtung zum Erzeugen eines Magnetfelds in der Schmelze, die dadurch gekennzeichnet ist, daß die Einrichtung zum Erzeugen des Magnetfelds um den Tiegel herum angeordnet ist und mindestens zwei Spulen umfaßt, wobei die eine Spule mit einer regelbaren Gleichstrom-Einheit verbunden ist und die andere Spule mit einer regelbaren Wechselstrom-Einheit verbunden ist.

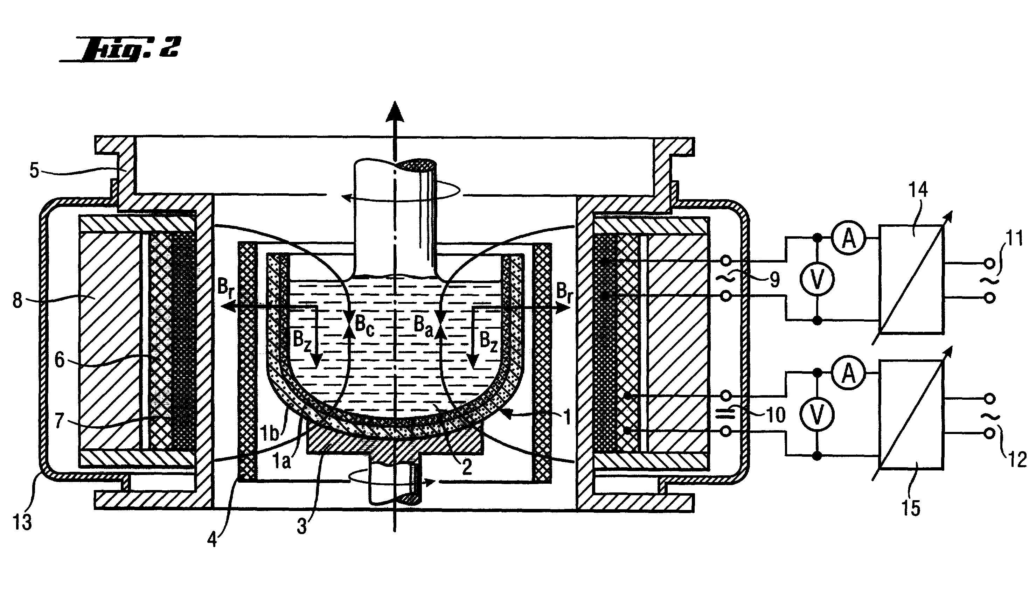

Eine derartige Vorrichtung ist in Figur 2 schematisch dargestellt. Die Figur zeigt nur die zum Verständnis der Erfindung notwendigen Merkmale. In dem Rezipienten 5 befindet sich der mit der Schmelze 2 gefüllte Tiegel 1. Der Tiegel 1 umfaßt einen inneren Quarztiegel 1a und einen äußeren Stütztiegel 1b. Der Tiegel 1 ist von einer Widerstandsheizung 4 koaxial umgeben und ruht auf einer drehbaren und axial bewegbaren Welle 3. Zwischen der Widerstandsheizung und der Rezipientenwand befinden sich übliche Hitzeschilde, die aber der besseren Übersicht wegen in der Figur weggelassen sind. Wesentliches Merkmal der Vorrichtung ist die das Magnetfeld erzeugende Einrichtung, die im wesentlichen ein magnetisches System 7 zur Erzeugung eines alternierenden Magnetfelds und ein magnetisches System 6 zur Erzeugung eines statischen Magnetfelds umfaßt und vorzugsweise von einem Ring 8 aus einem magnetischen Werkstoff umgeben ist. Sie ist außerhalb des Rezipienten 5 um den Tiegel 1 herum angeordnet und hat eine Höhe, die ungefähr der Höhe des Tiegels 1 entspricht. Im einfachsten Fall bestehen die magnetischen Systeme 6 und 7 aus je einer Spule. Das magnetische System 6 ist über den elektrischen Anschluß 10 mit der regelbaren Gleichstrom-Einheit 15 und der Stromversorgung 12 verbunden. Das magnetische System 7 ist über den elektrischen Anschluß 9 mit der regelbaren Wechselstrom-Einheit 14 und der Stromversorgung 11 verbunden. Eine Schutzhaube 13 schirmt die magnetische Einrichtung nach außen hin ab.

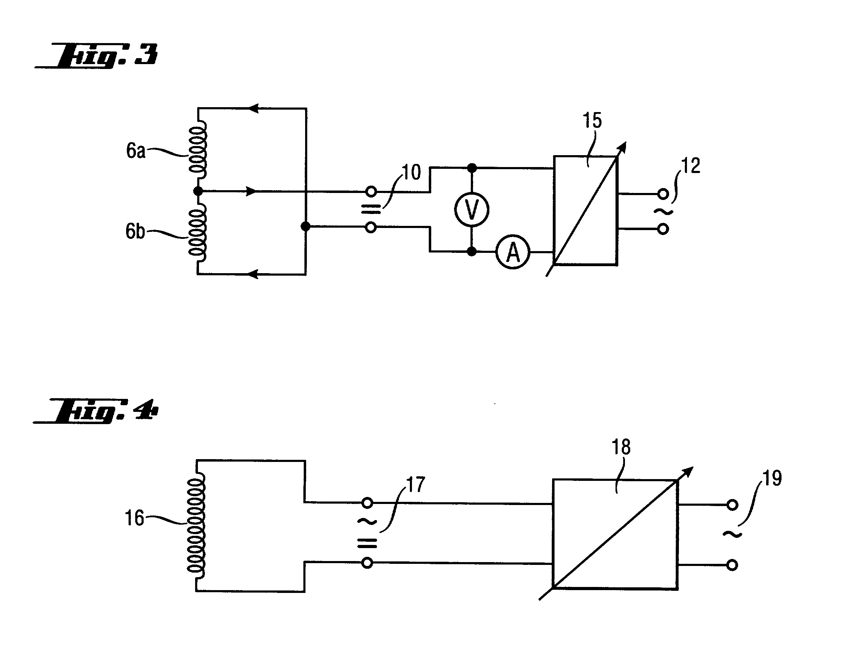

Figur 3 zeigt ein schematisches, elektrisches Diagramm für eine Vorrichtung gemäß einer zweiten Ausführungsform der Erfindung. Die Vorrichtung unterscheidet sich von der Vorrichtung gemäß Figur 2 in Bezug auf das magnetische System, das das statische Magnetfeld erzeugt. Dieses magnetische System besteht aus zwei Spulen 6a und 6b mit gleicher Windungszahl, die über den elektrischen Anschluß 10 mit der regelbaren Gleichstrom-Einheit 15 und der Stromversorgung 12 verbunden sind. Die Spulen 6a und 6b, die übereinander angeordnet sind, werden mit Gleichstrom entgegengesetzter Richtung versorgt. Sie erzeugen zwei statische Magnetfelder, die zueinander entgegengesetzt gerichtet sind.

Figur 4 zeigt ein schematisches, elektrisches Diagramm für eine Vorrichtung gemäß einer dritten Ausführungsform der Erfindung. Die Vorrichtung unterscheidet sich von der Vorrichtung gemäß Figur 2 in Bezug auf die magnetische Einrichtung. Die magnetische Einrichtung umfaßt nur eine Spule 16, die über den elektrischen Anschluß 17 mit dem regelbaren Gleichstrom/Wechselstrom-Wandler 18 und der Stromversorung 19 verbunden ist. Die Spule 16 erzeugt mit moduliertem Gleichstrom eine Kombination von statischem und alternierendem Magnetfeld in der Schmelze.

Nachfolgend wird die Erfindung an einem Beispiel beschrieben:

Der Quarzglastiegel einer gemäß Figur 2 umgebauten Vorrichtung zur Herstellung von Einkristallen wurde mit 4,6 kg Silicium und 96 mg einer Phosphor/Silicium-Legierung mit einer spezifischen Leitfähigkeit von ungefähr $2*10^{-3}$ $\Omega*cm$ gefüllt. Anschließend wurde der Rezipient evakuiert und mit einem konstanten Argonstrom bei einem Druck von 10 mbar gespült. Danach wurde die Widerstandsheizung angeschaltet und der Tiegel mit 5 Umdrehungen pro Minute gedreht. Die Spule zum Erzeugen des alternierenden Magnetfelds wurde etwa 30 Minuten später mit der Wechselstromquelle verbunden. Da die Spannungsquelle eine Wechselspannung von 150 Hz abgab, erzeugte die Spule ein alternierendes Magnetfeld im Tiegel, dessen relative Frequenz $\epsilon$ ungefähr 15 betrug. Die Wechselstromfrequenz war so gewählt worden, daß die Amplitude $B_a$ der magnetischen Induktion einen Wert von 0,02 T aufwies. Nachdem alles Material im Tiegel geschmolzen war, wurde die Schmelze noch 10 Minuten bei unveränderter Wärmezufuhr belassen, um eine vollständige Homogenisierung der Schmelze abzuwarten. Danach wurde auch das magnetische System zur Erzeugung des statischen Magnetfelds hinzugeschaltet und dessen Versorgung mit Gleichstrom langsam erhöht, bis eine magnetische Induktion $B_c = 0,1$ T erreicht war.

Vor dem Eintauchen des Impfkristalls in die Schmelze wurde die Heizleistung der Widerstandsheizung auf 15 kW zurückgeregelt. Die Zucht des Einkristalls erfolgte dann in üblicher Weise, mit dem Ziehen des Dünnhalses, des Anfangskonus, des zylindrischen Teils und des Endkonus des Einkristalls. Beim Ziehen des zylindrischen Teils mit einem Durchmesser von 80 mm und einer Länge von 250 mm drehte sich der Einkristall mit einer Geschwindigkeit von 15 Umdrehungen pro Minute. Die Ziehgeschwindigkeit betrug während dieser Phase 2 mm/min. Mit der Abnahme der Schmelzenhöhe wurde die Amplitude $B_a$ der magnetischen Induktion des alternierenden Magnetfelds bis zur Fertigstellung des Einkristalls von 0,02 T auf 0,04 T erhöht.

Die Analyse des zylindrischen Teils des abgekühlten Einkristalls ergab eine Schwankungsbreite beim axial gemessenen spezifischen Widerstand von 8 %. Weitere Ergebnisse von Messungen an erfindungsgemäß hergestellten Einkristallen sind in der nachfolgenden Tabelle zusammengestellt. Zum Vergleich sind auch entsprechende Ergebnisse von Einkristallen aufgelistet, deren Herstellung gemäß des Beispiels, jedoch ohne die Einwirkung eines Magnetfelds (No.1) oder nur mit Einwirkung eines statischen (No.2) oder alternierenden (No.3) Magnetfelds erfolgte. In der Tabelle bedeuten: $B_{ao}$ die Amplitude der magnetischen Induktion des alternierenden Magnetfelds zu Beginn des Wachstums des Einkristalls, $B_c$ die magnetische Induktion des statischen Magnetfelds, C die mittlere Sauerstoffkonzentration an der axialen Position $g*$ im Einkristall, $\Delta C$ die radiale Schwankungsbreite der Sauerstoffkonzentration und $\Delta\sigma$ die radiale Schwankungsbreite der Dotierstoffverteilung. Der Parameter $g*$ gibt die relative axiale Meßposition an. Er ist definiert als g/G, wobei g die bis zu dieser Position kristallisierte Masse und G die Masse der Schmelze ist.

5

Tabelle:

| No. | $B_{ao}$ [T] | $B_c$ [T] | g* | C [at/cm3] $*10^{-17}$ | $\Delta C$ [%] | umfaßt.$\Delta\sigma$ [%] |
|---|---|---|---|---|---|---|
| 1 | 0 | 0 | 0,08 | 10,8 | 11,5 | 7,2 |
|   |   |   | 0,25 | 9,9 | 5,3 | 9,1 |
|   |   |   | 0,55 | 9,5 | 8,8 | 8,8 |
|   |   |   | 0,8 | 8,2 | 10,4 | 11,3 |
| 2 | 0 | 0,1 | 0,07 | 8,2 | 8,5 | 6,7 |
|   |   |   | 0,25 | 7,5 | 7,0 | 7,4 |
|   |   |   | 0,5 | 6,8 | 5,8 | 6,4 |
|   |   |   | 0,8 | 7,4 | 6,2 | 6,5 |
| 3 | 0,03 | 0 | 0,08 | 10,1 | 7,2 | 5,0 |
|   |   |   | 0,3 | 9,5 | 6,5 | 5,4 |
|   |   |   | 0,6 | 10,6 | 6,1 | 5,7 |
|   |   |   | 0,8 | 9,8 | 5,8 | 5,6 |
| 4 | 0,04 | 0,1 | 0,07 | 2,8 | 2,4 | 2,0 |
|   |   |   | 0,25 | 3,2 | 2,7 | 2,4 |
|   |   |   | 0,5 | 3,4 | 3,1 | 2,7 |
|   |   |   | 0,8 | 3,6 | 3,2 | 2,6 |
| 5 | 0,005 | 0,1 | 0,08 | 4,8 | 4,7 | 4,7 |
|   |   |   | 0,3 | 5,5 | 5,2 | 4,1 |
|   |   |   | 0,6 | 5,8 | 5,4 | 5,2 |
|   |   |   | 0,8 | 6,2 | 6,6 | 5,4 |
| 6 | 0,015 | 0,1 | 0,08 | 3,1 | 2,7 | 2,8 |
|   |   |   | 0,25 | 3,4 | 2,4 | 2,6 |
|   |   |   | 0,5 | 3,5 | 2,4 | 2,1 |
|   |   |   | 0,8 | 3,5 | 2,6 | 2,4 |

Die Meßwerte zeigen deutlich die Verbesserungen, die bei Anwendung einer Kombiniation eines alternierenden und eines statischen Magnetfelds in bezug auf die Homogenität der Dotierstoff- und Sauerstoffverteilung zu erwarten sind. Sie zeigen auch, daß niedrige Sauerstoffkonzentrationen in Einkristallen gezielt eingestellt werden können.

## Patentansprüche

1. Verfahren zur Herstellung eines Einkristalls aus Halbleitermaterial nach der Czochralski-Methode durch Wegziehen eines in eine Schmelze getauchten Impfkristalls von der Oberfläche der Schmelze, wobei sich die Schmelze bis zu einer bestimmten Höhe in einem drehbaren Quarzglastiegel befindet und durch Aufschmelzen von festem Halbleitermaterial und gegebenenfalls Dotierstoffen erzeugt wird, und die Schmelze während des Kristallwachstums unter dem Einfluß eines Magnetfelds steht, das dadurch gekennzeichnet ist, daß das Magnetfeld durch Überlagern eines statischen Magnetfelds und eines alternierenden Magnetfelds erzeugt wird.

2. Verfahren nach Anspruch 1, dadurch gekennzeichnet, daß das statische Magnetfeld eine magnetische Induktion $B_c = \sqrt{B_r^2 + B_z^2}$ aufweist, deren Betrag gleich oder größer ist als 0,05 T, wobei $B_r$ und $B_z$ die radialen und axialen Komponenten der magnetischen Induktion bezüglich der Drehachse des Tiegels sind und das statische Magnetfeld axial, transversal oder axial-radial ausgerichtet ist.

3. Verfahren nach Anspruch 1, dadurch gekennzeichnet, daß das alternierende Magnetfeld eine relative Frequenz $\varepsilon = 2\pi\mu_o\sigma fR^2$ besitzt, die im Bereich von 1 bis 1000, vorzugsweise von 5 bis 50 liegt, und eine magnetische Induktion mit einer Amplitude von mindestens $B_a = C/R$ aufweist, wobei $\mu_o$ die magnetische Permeabilität im Vakuum ist ($\mu_o = 4\pi10^{-7}$ H/m) und $\sigma$ die elektrische Leitfähigkeit der Schmelze, f die Wechselstromfrequenz der Stromversorgung des Magneten und R der Radius des Tiegels bedeuten und C eine Konstante ist, deren Wert $1*10^{-3}$ T$*$m beträgt.

4. Verfahren nach Anspruch 1, dadurch gekennzeichnet, daß auf die beim Ziehen des Einkristalls erfolgende Abnahme der Schmelzenhöhe mit einer Änderung der Amplitude der magnetischen Induktion des alternierenden Magnetfelds gemäß der Gleichung $B_a = B_{ao}*\sqrt{h_o/h}$ reagiert wird, wobei $B_a$ die geänderte Amplitude, $B_{ao}$ die anfängliche Amplitude, h die tatsächliche Schmelzenhöhe und $h_o$ die anfängliche Schmelzenhöhe sind.

5. Verfahren nach Anspruch 1, dadurch gekennzeichnet, daß das alternierende Magnetfeld eine relative Frequenz $\varepsilon = 2\pi\mu_o\sigma fR^2$ besitzt, die im Bereich von 1 bis 1000, vorzugsweise von 5 bis 50 liegt, und eine magnetische Induktion mit einer Amplitude von mindestens $B_a = C/R$ aufweist, wobei $\mu_o$ die magnetische Permeabilität im Vakuum ist ($\mu_o = 4\pi10^{-7}$ H/m) und $\sigma$ die elektrische Leitfähigkeit der Schmelze, f die Wechselstromfrequenz der Stromversorgung des Magneten und R der Radius des Tiegels bedeuten und C eine Konstante ist, deren Wert $1*10^{-3}$ T$*$m beträgt, und der Einbau von Sauerstoff in den Einkristall über die Amplitude des Magnetfelds und die relative Frequenz $\varepsilon$ gesteuert wird.

6. Verfahren nach Anspruch 1, dadurch gekennzeichnet, daß das festes Halbleitermaterial vor Beginn des Kristallzugs mit Hilfe einer Widerstandsheizung und mit Hilfe des alternierenden Magnetfelds aufgeschmolzen wird.

7. Verfahren nach Anspruch 1, dadurch gekennzeichnet, daß festes Halbleitermaterial während des Ziehens des Einkristalls in den Tiegel nachchargiert wird und mit Hilfe einer Widerstandsheizung und des alternierenden Magnetfelds aufgeschmolzen wird.

8. Verfahren nach Anspruch 1, dadurch gekennzeichnet, daß der Schmelze während des Ziehens des Einkristalls mit Hilfe einer Widerstandsheizung und der sich überlagernden Magnetfelder ein radiales Temperaturprofil aufgeprägt wird, welches zwischen dem Einkristall und der Tiegelwand ein Temperaturmaximum aufweist und an der Tiegelwand und im Bereich der Kristallisationsgrenze Temperaturen vorsieht, die nur geringfügig über dem Schmelzpunkt des Halbleitermaterials liegen.

9. Verfahren nach Anspruch 1, dadurch gekennzeichnet, daß der Schmelze während des Ziehens des Einkristalls mit Hilfe einer Widerstandsheizung und der sich überlagernden Magnetfelder ein radiales Temperaturprofil aufgeprägt wird, welches zwischen dem Einkristall und der Tiegelwand ein Temperaturmaximum aufweist und an der Tiegelwand Temperaturen vorsieht, die unter dem Schmelzpunkt des Halbleitermaterials liegen.

10. Vorrichtung zur Herstellung eines Einkristalls aus Halbleitermaterial nach der Czochralski-Methode, mit einem Rezipienten, in dem ein mit einer Schmelze gefüllter Tiegel und eine den Tiegel umgebende Widerstands-Heizung untergebracht sind, mit einer Zieheinrichtung zum Ziehen eines Einkristalls aus der Schmelze und mit einer Einrichtung zum Erzeugen eines Magneffelds in der Schmelze, dadurch gekennzeichnet, daß die Einrichtung zum Erzeugen des Magneffelds um den Tiegel herum angeordnet ist und mindestens zwei Spulen umfaßt, wobei die eine Spule mit einer regelbaren Gleichstrom-Einheit verbunden ist und die andere Spule mit einer regelbaren Wechselstrom-Einheit verbunden ist.

11. Vorrichtung nach Anspruch 10, gekennzeichnet, durch eine weitere, mit der regelbaren Gleichstrom-Einheit verbundenen Spule mit gleicher Windungszahl wie die der Spule, die mit der regelbaren Gleichstrom-Einheit verbunden ist, wobei diese Spulen übereinander angeordnet sind und mit Gleichstrom entgegengesetzter Richtung versorgt werden.

12. Vorrichtung nach Anspruch 10, dadurch gekennzeichnet, daß die Einrichtung zum Erzeugen des Magneffelds von einem Ring aus einem magnetischen Werkstoff umgeben ist.

13. Vorrichtung zur Herstellung eines Einkristalls aus Halbleitermaterial nach der Czochralski-Methode, mit einem Rezipienten, in dem ein mit einer Schmelze gefüllter Tiegel und eine den Tiegel umgebende Widerstands-Heizung untergebracht sind, mit einer Zieheinrichtung zum Ziehen eines Einkristalls aus der Schmelze und mit einer Einrichtung zum Erzeugen eines Magneffelds in der Schmelze, dadurch gekennzeichnet, daß die Einrichtung zum Erzeugen des Magneffelds mindestens eine Spule umfaßt, die mit einem regelbaren Gleichstrom/Wechselstromwandler verbunden ist, der Gleichstrom mit überlagerten Wechselstromanteilen abgibt, so daß die Spule ein kombiniert statisches und altemierendes Magnetfeld erzeugt.

14. Vorrichtung nach Anspruch 13, dadurch gekennzeichnet, daß die Einrichtung zum Erzeugen des Magneffelds von einem Ring aus einem magnetischen Werkstoff umgeben ist.

## Claims

1. Process for the growth of a single crystal from semiconductor material by the Czochralski method by drawing a seed crystal immersed in a melt away from the surface of the melt, the melt being present up to a certain height in a rotatable quartz glass crucible and being produced by melting solid semiconductor material and optionally dopants, and the melt being subjected to the influence of a magnetic field during the crystal growth, characterized in that the magnetic field is generated by superposing a static magnetic field and an alternating magnetic field.

2. Process according to Claim 1, characterized in that the static magnetic field has a magnetic induction $B_c = \sqrt{B_r^2 + B_z^2}$ whose magnitude is equal to or greater than 0.05 T, $B_r$ and $B_z$ being the radial and axial components of the magnetic induction with respect to the axis of rotation of the crucible and the static magnetic field being oriented axially, transversely or axially-radially.

3. Process according to Claim 1, characterized in that the alternating magnetic field has a relative frequency $\varepsilon = 2\pi\mu_o\sigma fR^2$ which is in the range from 1 to 1000, preferably from 5 to 50 and has a magnetic induction with an amplitude of at least $B_a = C/R$, where $\mu_o$ denotes the magnetic permeability in vacuo ($\mu_o = 4\pi10^{-7}$ H/m) and $\sigma$ denotes the electrical conductivity of the melt, f denotes the alternating current frequency of the power supply of the magnet and R denotes the radius of the crucible and C is a constant whose value is $1\cdot10^{-3}$ T·m.

4. Process according to Claim 1, characterized in that the decrease in the melt height which occurs during drawing of the single crystal is responded to by a change in the amplitude of the magnetic induction of the alternating magnetic field according to the equation $B_a = B_{ao}\cdot\sqrt{h_o/h}$ , where $B_a$ is the changed amplitude, $B_{ao}$ is the initial amplitude, h is the actual melt height and $h_o$ is the initial melt height.

5. Process according to Claim 1, characterized in that the alternating magnetic field has a relative frequency $\varepsilon = 2\pi\mu_o\sigma fR^2$ which is in the range from 1 to 1000, preferably from 5 to 50 and has a magnetic induction with an amplitude of at least $B_a = C/R$, where $\mu_o$ denotes the magnetic permeability in vacuo ($\mu_o = 4\pi10^{-7}$ H/m) and $\sigma$ denotes the electrical conductivity of the melt, f denotes the alternating current frequency of the power supply of the magnet and R denotes the radius of the crucible and C is a constant whose value is $1\cdot10^{-3}$ T·m, and the incorporation of oxygen into the single crystal is controlled via the amplitude of the magnetic field and the relative frequency $\varepsilon$.

6. Process according to Claim 1, characterized in that the solid semiconductor material is melted, before the beginning of drawing of the crystal, with the aid of a resistance heating and with the aid of the alternating magnetic field.

7. Process according to Claim 1, characterized in that solid semiconductor material is subsequently added to the crucible during drawing of the single crystal and is melted with the aid of a resistance heating and of the alternating magnetic field.

8. Process according to Claim 1, characterized in that a radial temperature profile which has a temperature maximum between the single crystal and the crucible wall and provides, at the crucible wall and in the region of the crystallization boundary, temperatures which are only slightly above the melting point of the semiconductor material is applied to the melt, during growing of the single crystal, with the aid of a resistance heating and of the superposed magnetic fields.

9. Process according to Claim 1, characterized in that a radial temperature profile which has a temperature maximum between the single crystal and the crucible wall and provides, at the crucible wall, temperatures which are below the melting point of the semiconductor material is applied to the melt, during drawing of the single crystal, with the aid of a resistance heating and of the superposed magnetic fields.

10. Apparatus for the growth of a single crystal from semiconductor material by the Czochralski method, having a receptacle in which a melt-filled crucible and a resistance heating surrounding the crucible are housed, having a drawing means for growing a single crystal from the melt and having a means for generating a magnetic field in the melt, characterized in that the means for generating the magnetic field is arranged around the crucible and comprises at least two coils, one coil being connected to an adjustable direct current unit and the other coil being connected to an adjustable alternating current unit.

**11.** Apparatus according to Claim 10, characterized by a further coil which is connected to the adjustable direct current unit and which has the same number of windings as the coil which is connected to the adjustable direct current unit, said coils being arranged one above the other and being fed with direct current of opposite direction.

**12.** Apparatus according to Claim 10, characterized in that the means for generating the magnetic field is surrounded by a ring of a magnetic material.

**13.** Apparatus for the growth of a single crystal from semiconductor material by the Czochralski method, comprising a receptacle for housing a melt-filled crucible and a resistance heating means surrounding the crucible, a drawing means for growing a single crystal from the melt and a means for generating a magnetic field in the melt, characterized in that the means for generating the magnetic field comprises at least one coil which is connected to an adjustable direct current/alternating current converter which outputs direct current with superposed alternating current components so that the coil generates a combined static and alternating magnetic field.

**14.** Apparatus according to Claim 13, characterized in that the means for generating the magnetic field is surrounded by a ring of a magnetic material.

## Revendications

**1.** Procédé pour la préparation d'un monocristal à partir d'un matériau semi-conducteur selon le procédé de Czochralski en retirant un germe immergé dans un bain fondu de la surface du bain fondu, le bain fondu atteignant une certaine hauteur dans un creuset de verre quartzeux rotatif et étant produit en faisant fondre le matériau semi-conducteur solide et, éventuellement, des agents dopants, et le bain fondu étant soumis à l'action d'un champ magnétique au cours de la croissance du cristal, caractérisé en ce que le champ magnétique est généré en superposant un champ magnétique statique et un champ magnétique alternatif.

**2.** Procédé selon la revendication 1, caractérisé en ce que le champ magnétique statique présente une induction magnétique $Bc = \sqrt{B_r^2 + B_z^2}$, dont la grandeur est égale ou supérieure à 0,05 T, $B_r$ et $B_z$ étant les composantes radiale et axiale de l'induction magnétique par rapport à l'axe de rotation du creuset et le champ magnétique statique étant dirigé axialement, transversalement ou axialement-radialement.

**3.** Procédé selon la revendication 1, caractérisé en ce que le champ magnétique alternatif a une fréquence relative $\varepsilon = 2\pi\mu_o\sigma fR^2$ qui se situe dans la plage de 1 à 1000, de préférence de 5 à 50, et présente une induction magnétique d'une amplitude d'au moins $B_a = C/R$, où $\mu_0$ est la perméabilité magnétique sous vide ($\mu_0 = 4\pi10^{-7}$ H/m), $\sigma$ désigne la conductivité électrique du bain fondu, f désigne la fréquence du courant alternatif de l'alimentation en courant de l'aimant, et R désigne le rayon du creuset et C est une constante dont la valeur est de $1*10^{-3}$ T*m.

**4.** Procédé selon la revendication 1, caractérisé en ce que la réduction de la hauteur du bain fondu qui se produit au cours du tirage du monocristal entraîne une modification de l'amplitude de l'induction magnétique du champ magnétique alternatif selon l'équation $B_a = B_{a0}*\sqrt{h_0/h}$, dans laquelle $B_a$ est l'amplitude modifiée, $B_{a0}$ est l'amplitude initiale, h est la hauteur réelle du bain fondu et $h_0$ est la hauteur du bain fondu initial.

**5.** Procédé selon la revendication 1, caractérisé en ce que le champ magnétique alternatif possède une fréquence relative $\varepsilon = 2\pi\mu_0\sigma fR^2$ qui se situe dans la plage de 1 à 1000, de préférence de 5 à 50, et présente une induction magnétique à une amplitude d'au moins $B_a = C/R$, où $\mu_0$ désigne la perméabilité magnétique sous vide ($\mu_0 = 4\pi10^{-7}$ H/m) et $\sigma$ désigne la conductivité électrique du bain fondu, f désigne la fréquence du courant alternatif de l'alimentation en courant de l'aimant, et R désigne le rayon du creuset et C est une constante dont la valeur est de $1*10^{-3}$ T*m, et l'incorporation d'oxygène au monocristal est régie par l'amplitude du champ magnétique et la fréquence relative $\varepsilon$.

**6.** Procédé selon la revendication 1, caractérisé en ce que le matériau semi-conducteur solide est fondu, avant le début du tirage du cristal, à l'aide d'un chauffage ohmique et à l'aide du champ magnétique alternatif.

7. Procédé selon la revendication 1, caractérisé en ce qu'on refait l'appoint en matériau semi-conducteur solide dans le creuset au cours du tirage du monocristal et on le fond à l'aide d'un chauffage ohmique et du champ magnétique alternatif.

8. Procédé selon la revendication 1, caractérisé en ce que, au cours du tirage du monocristal, on applique au moyen d'un chauffage ohmique et des champs magnétiques superposés un profil de température radial qui présente une température maximale entre le monocristal et la paroi du creuset et prévoit, sur la paroi du creuset et dans la zone de la limite de cristallisation, des températures qui ne se situent que légèrement au-dessus du point de fusion du matériau semi-conducteur.

9. Procédé selon la revendication 1, caractérisé en ce que, au cours du tirage du monocristal, on applique au moyen d'un chauffage ohmique et des champs magnétiques superposés un profil de température radial qui présente une température maximale entre le monocristal et la paroi du creuset et prévoit, sur la paroi du creuset, des températures qui se situent en dessous du point de fusion du matériau semi-conducteur.

10. Appareil pour la préparation d'un monocristal à partir d'un matériau semi-conducteur par le procédé de Czochralski, comprenant un réceptacle dans lequel sont logés un creuset rempli d'un bain fondu et un chauffage ohmique entourant le creuset, un dispositif de tirage pour tirer un monocristal du bain fondu et un dispositif pour générer un champ magnétique dans le bain fondu, caractérisé en ce que le dispositif pour générer le champ magnétique est agencé autour du creuset et comprend au moins deux bobines, la première bobine étant connectée à une unité de courant continu réglable et l'autre bobine étant connectée à une unité de courant alternatif réglable.

11. Appareil selon la revendication 10, caractérisé par une autre bobine qui est connectée à l'unité de courant continu réglable et qui a le même nombre d'enroulements que la bobine qui est connectée à l'unité de courant continu réglable, lesdites bobines étant agencées l'une au-dessus de l'autre et étant alimentées par un courant continu de sens opposé.

12. Appareil selon la revendication 10, caractérisé en ce que le dispositif pour générer le champ magnétique est entouré d'un anneau constitué d'un matériau magnétique.

13. Appareil pour la préparation d'un monocristal à partir d'un matériau semi-conducteur par le procédé de Czochralski, comprenant un réceptacle dans lequel sont logés un creuset rempli d'un bain fondu et un chauffage ohmique entourant le creuset, un dispositif de tirage pour tirer un monocristal du bain fondu et un dispositif pour générer un champ magnétique dans le bain fondu, caractérisé en ce que le dispositif pour générer le champ magnétique comprend au moins une bobine qui est connectée à un convertisseur réglable courant continu/courant alternatif qui délivre un courant continu avec des composantes superposées de courant alternatif, de telle sorte que la bobine génère à la fois un champ magnétique statique et un champ magnétique alternatif.

14. Appareil selon la revendication 13, caractérisé en ce que le dispositif pour générer le champ magnétique est entouré d'un anneau constitué d'un matériau magnétique.

Fig. 1

Fig. 2

EP 0 758 689 B1

12

Fig. 3

Fig. 4